# EUROPEAN PATENT SPECIFICATION

(11) **EP 2 086 298 B1**
(45) Date of publication and mention of the grant of the patent: **13.03.2013**
(21) Application number: 08150847.5
(22) Date of filing: 30.01.2008
(51) Int. Cl.: H05K 3/34

(54) **Solder void reduction on circuit boards**
Lötstellenverringerung auf Leiterplatten
Réduction de cavité de soudure sur des cartes de circuit

(43) Date of publication of application: 05.08.2009
(73) Proprietor: Research In Motion Limited, Waterloo, ON N2L 3W8 (CA)
(72) Inventor: Khan, Atiq, Cambridge Ontario N1T 2H7 (CA)
(74) Representative: MERH-IP Matias Erny Reichl Hoffmann

(56) References cited:
- JP-A- 8 288 631
- US-A- 5 875 102
- US-A1- 2003 123 234

## Description

The present invention relates generally to a method for reducing voids at solder connection points on circuit boards.

In electronics assembly and manufacturing, a printed circuit board (PCB) is often used to lay down circuits and to provide a base for mounting various types of electronic components. The circuits in the PCBs may comprise electrically conductive pathways traced or etched from conductive material (e.g. copper sheets) onto a non-conductive substrate. Multiple layers of these conductive pathways may be separated by alternating layers of non-conductive substrates in order to form a laminate board that may include many layers of circuits and non-conductive substrates.

In order to electrically connect the circuits in one or more of the conductive layers, "via holes" - namely deliberately formed cavities - may be drilled into the laminate layers of the PCB. Alternatively, the via holes may be formed by evaporating the laminate layers using laser, but this alternative method is thought to be generally less accurate than mechanical drilling. Once the via hole is formed, the inner walls of the holes are plated with copper or another conductive material such that any overlapping conductive pathways located at the point of the via hole are electrically connected between layers. The depth of the drilling may be controlled to connect only some of the layers in the PCB, or the via hole may be drilled straight through the laminate board.

Components are then placed on the PCB at predetermined connection points provided on the outer surfaces of the PCB in order to build various parts of the circuit required for the designed operation of the PCB. Generally speaking, electronic components with leads are attached to the PCB at connection points defined by conductive landing pads or connectors provided on the surface of the PCB to receive the component leads. For electronic components that are to be permanently attached to the PCB, the electrical and mechanical connections between the component leads and the conductive landing pads are typically made using a suitable soldering paste or compound. This solder connection must be strong enough to provide good electrical contact between the electronic component lead and the conductive landing pad, but also provide a strong mechanical connection in order to keep the component in place and provide reliable performance over the long term.

US 2003/123234A1 discloses a printed wiring board including a substrate having a packaging surface and at least one pad mounted on the packaging surface. The pad has an area to solder a circuit component. At least one connection part is placed in the area of the pad. The connection part is electrically insulated from the pad and connected to a circuit electrically different from the pad.

US 5875102A discloses a ball grid array (BGA) integrated circuit package which has a plurality or vias connected to a plurality of solder pads located on a bottom surface of a package substrate. Each via has a portion located within a solder pad to increase the routing space of the substrate, and a portion located outside the solder pad to allow outgassing from the via. The bottom surface also has a solder mask which covers the vias and contains a number of holes that expose the solder pads. The holes allow solder balls to be attached to the solder pads. The solder balls can be reflowed to attach the package to a printed circuit board.

### GENERAL

In an embodiment, there may be provided a method of reducing solder voids on a circuit board, comprising: locating via holes provided at a conductive landing pad; and covering at least some of the via holes with a coating, whereby gases from the covered via holes are prevented from expanding and forming voids.

In another embodiment, the method may further comprise covering the location of at least some of the via holes in a pattern of strips, whereby more of the via holes may be covered by the coating while reducing areas of the conductive landing pad covered by the coating.

In another embodiment, covering at least some of the via holes may comprise: positioning a screen over the circuit board, the screen covering the location of at least some of the via holes; exposing areas of the coating at the conductive landing pad left uncovered by the screen to a coating removal agent; and removing the coating from areas of the conductive landing pad exposed to the coating removal agent.

In another embodiment, the screen may be a photo mask.

In another embodiment, the method may further comprise: positioning a screen over the circuit board, the screen covering the location of the at least some of the via holes; exposing areas of the coating at the conductive landing pad left uncovered by the screen to a chemical etching agent; and removing the coating from areas of the conductive landing pad exposed to the chemical etching agent.

In another embodiment, the method may further comprise: positioning a screen over the circuit board, the screen leaving the location of the at least some of the via holes uncovered; and applying the coating to the via holes left uncovered by the screen.

In another embodiment, the method may further comprise: covering at least some of the via holes provided at a conductive landing pad at the same time that all other areas of the circuit board are covered; and removing the coating from desired areas of the conductive landing pad at the same time that the coating is removed from all other areas of the circuit board.

In another aspect, there may be provided a system for reducing solder voids on a circuit board, the system adapted to locate via holes provided at a conductive landing pad, and cover at least some of the via holes with a coating, whereby gases from the covered via holes are prevented from expanding and forming voids.

In an embodiment, the system may further be adapted to cover the location of at least some of the via holes in a pattern of strips, whereby more of the via holes may be covered by the coating while reducing areas of the conductive landing pad covered by the coating.

In another embodiment, the system may further be adapted to cover at least some of the via holes by: positioning a screen over the circuit board, the screen covering the location of at least some of the via holes; exposing areas of the coating at the conductive landing pad left uncovered by the screen to a coating removal agent; and removing the coating from areas of the conductive landing pad exposed to the coating removal agent.

In another embodiment, the screen may be a photo mask.

In another embodiment, the system may be further adapted to cover at least some of the via holes by: positioning a screen over the circuit board, the screen covering the location of the at least some of the via holes; exposing areas of the coating at the conductive landing pad left uncovered by the screen to a chemical etching agent; and removing the coating from areas of the conductive landing pad exposed to the chemical etching agent.

In another embodiment, the system may be further adapted to cover at least some of the via holes by: positioning a screen over the circuit board, the screen leaving the location of at least some of the via holes uncovered; and applying the coating to the via holes left uncovered by the screen.

In another aspect, there may be provide a screen for use in screening a coating applied a circuit board, the screen adapted to leave a coating covering one or more via holes located at a conductive landing pad, whereby gases from the covered via holes are prevented from expanding and forming voids.

In an embodiment, the screen may be adapted to cover the coating applied over one or more via holes located at a conductive landing pad provided on the circuit board, whereby the coating remains over at least some via holes located at the conductive landing pad area.

In another embodiment, the screen may be adapted to cover the via holes in a pattern, whereby more of the via holes may be left covered by the coating while reducing areas of the conductive landing pad left covered by the coating.

In another embodiment, the pattern may be a strip configured to cover a plurality of via holes across the conductive landing pad.

In another embodiment, the strip may be a straight strip configured to cover a plurality of via holes aligned across the conductive landing pad.

In another embodiment, the screen may comprise positioning guides to accurately position the screen to cover the coating applied over at least some via holes located at the conductive landing pad.

In another embodiment, the screen may be adapted to leave uncovered one or more via holes located at a conductive landing pad provided on the circuit board, whereby a coating may be applied to the one or more via holes left uncovered by the screen.

### BRIEF DESCRIPTION OF THE DRAWINGS

In the figures which illustrate exemplary embodiments:
FIG. 1 shows illustrative plan view X-ray images showing large voids that have formed at a solder connection point connecting a component lead to a conductive landing pad;
FIG. 2 shows a schematic block diagram of an illustrative system for reducing solder voids on circuit boards in accordance with an embodiment;
FIGS. 3A to 3C are illustrative plan view images of solder masking of via holes in accordance with various embodiments;
FIG. 4 shows an illustrative plan view of a screen or photo mask in accordance with an embodiment;
FIG. 5 shows illustrative plan view X-ray images showing significantly reduced voids resulting from solder masking of via holes in accordance with various embodiments; and
FIG. 6 shows an illustrative flowchart of a method in accordance with an embodiment.

### DESCRIPTION OF PREFERRED EMBODIMENTS

As noted above, the present invention relates to a method for reducing the size of voids or pockets of air at solder connection points on a circuit board.

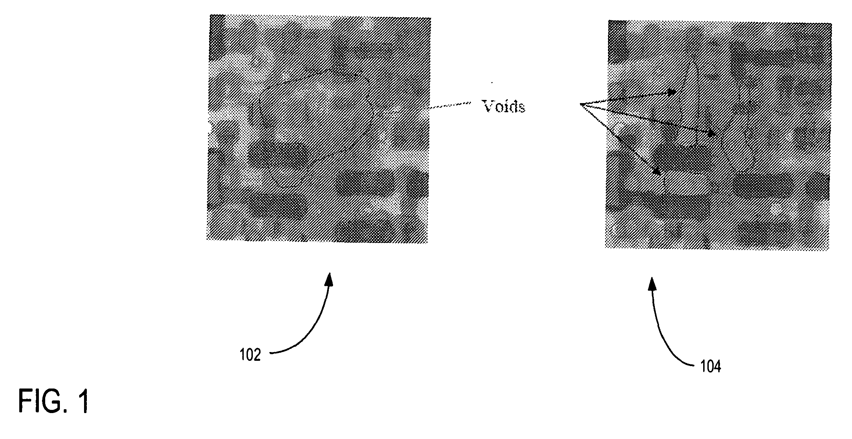

Referring to FIG. 1, during manufacture and assembly of certain PCBs, the inventor noticed several PCB part numbers having a very high degree of void formation at solder connections, representing an average of approximately 22% of the total potential solder connection surface area. Illustrative examples of these voids are shown in FIG. 1, in which X-ray images 102 and 104 of two solder connection points show large pockets of air that have formed between the solder and the conductive landing pad.

The problem of large voids forming at solder joints and within a solder connection is that there is a significant reduction in the solder surface area that is in contact with the conductive landing pad. This reduced connection area may result in an increased probability that the connection may fail prematurely, either electrically or mechanically, over time.

In order to identify the source of the void formation problem, the inventor first conducted a series of tests, including using a different oven reflow profile for liquefying the solder paste and then hardening the melted solder. The inventor also tried different screen aperture designs for providing different volumes and patterns of solder paste on conductive landing pad geometries. However, the inventor found that there was no consistent improvement seen by modifying the reflow profile, or by modifying the screen design to provide a different volume and pattern of solder paste on pad geometry. However, from these series of tests, the inventor finally realized that the problem of large voids forming at the solder joints was as a result of via holes drilled into the conductive landing pads, which contained trapped air. This air expanded significantly during the oven reflow process to form voids or pockets of air within the solder joint, and these voids were then fixed in position during the subsequent solder cooling and hardening process. As a result, the inventor started investigating potential solutions for dealing with the venting of gasses from the via holes.

The inventor considered reducing voids by filling the via holes with copper inserts, but given the potential for hundreds of via holes on a PCB and the very small size of the via holes, it was impractical and costly to implement this solution. Also, an additional assembly step was required to add the copper inserts.

After further experimentation, the inventor discovered that the problem could be solved by modifying a step that was already being used during the PCB manufacturing process. Namely, a non-conductive coating was being applied to the outer surfaces of the PCBs, and a photo masking process was being used to expose and then to remove certain areas of the non-conductive coating, thereby leaving conductive surface areas or pads exposed to allow connection of component leads. The inventor realized that some of the via holes located at the conductive landing pad locations could be left covered with the non-conductive coating instead of being removed during the coating removal process, thereby leaving fewer via holes available to contact the solder. As will be explained in more detail further below, this had the result of significantly reducing the formation and size of voids, thereby increasing the solder connection surface area at the conductive landing pad. It is believed that the non-conductive surface coating applied to the PCB work to either significantly reduce or remove the air trapped within the via holes, or effectively prevents the air trapped within the via holes from escaping during the oven reflow process, or some combination of both.

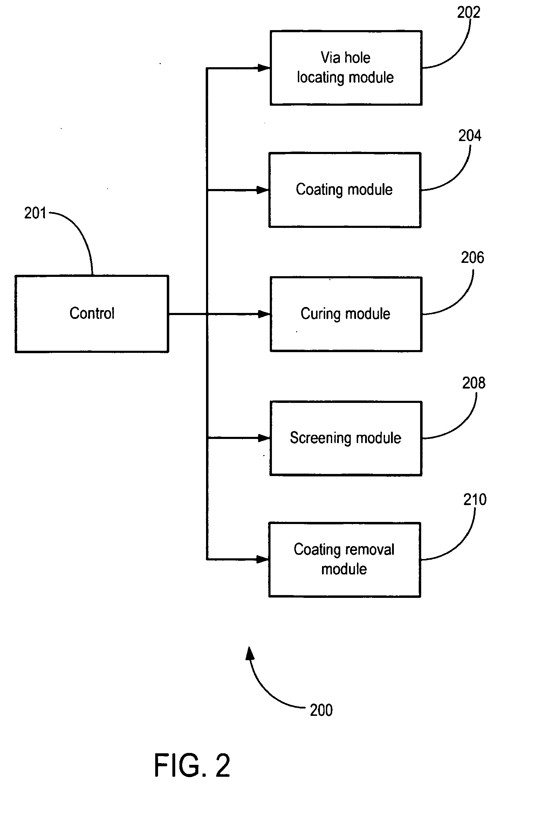

FIG. 2 shows a schematic block diagram of an illustrative system 200 for reducing voids in circuit boards in accordance with an embodiment. As shown, system 200 includes a control 201 for controlling the manufacturing process for the circuit boards or PCBs. System 200 may further include a via hole locating module 202 for locating via holes provided at a conductive landing pad on a PCB. For example, the via hole locating module may include schematic x-y coordinates, relative to a reference point, of the locations and boundaries of the conductive landing pads, and the positions of all of the via holes provided at the conductive landing pads.

System 200 may further include a coating module 204 for applying a coating to the PCB. Coating module may be adapted to apply a non-conductive solder mask coating to the outer surface of the PCB. System 200 may further include a curing module 206 for curing the coating applied by the coating module 204.

Still referring to FIG. 2, system 200 may also include a screening module 208 adapted to position a screen on the PCB, such that portions of the PCB may be covered or exposed as desired. Screening module 208 may be integrated with a submodule to apply a coating removal agent to the exposed portions of the PCB. At coating removal module 210, the coating applied by the coating module 204 at portions of the PCB exposed to the coating removal agent may be removed.

In an alternative embodiment, instead of having the coating applied by the coating module 204 and removed by the coating removal module, the coating may be applied at screening module 208 by using a "negative" screen and by applying the coating to areas of the PCB exposed by the screen. However, it will be appreciated that this may require a separate manufacturing step, with the coating applied to only certain areas of the PCB at conductive landing pads where it is desired to coat the via holes.

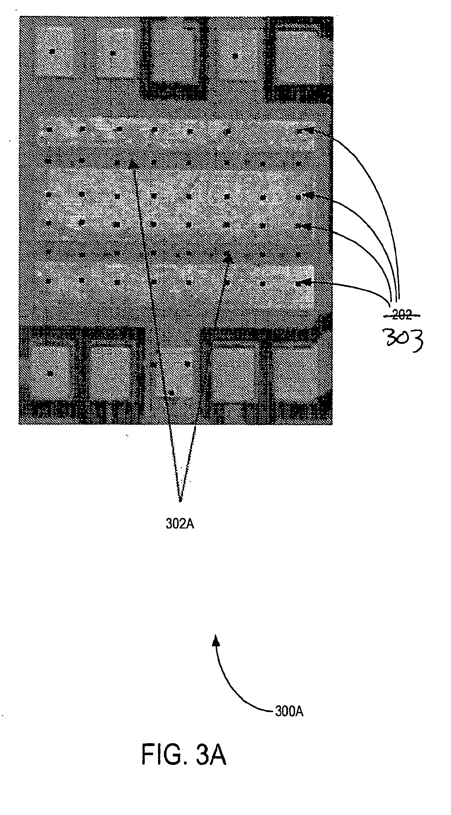

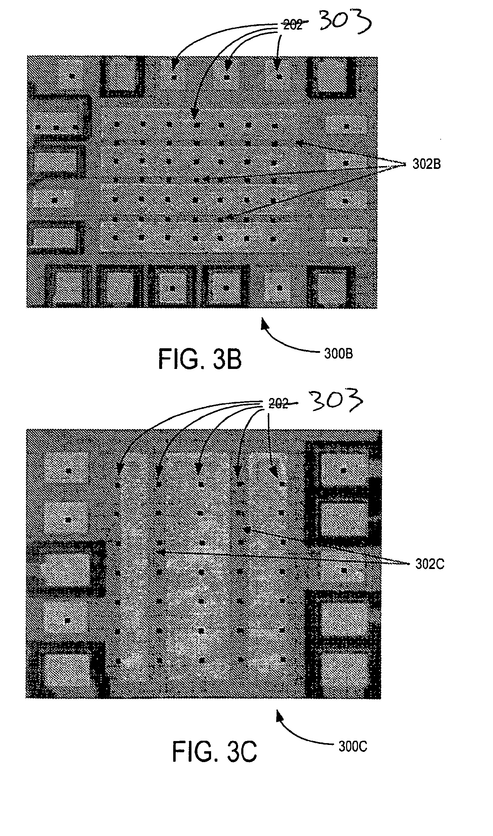

Illustrative plan view images of conductive landing pad geometries modified in accordance with various embodiments are shown in FIGS. 3A to 3C. These are photo images of different pad geometries with dots that have been graphically added to more clearly show the locations of the via holes 303. For example, as shown in FIG. 3A, at least some of the via holes 303 have been left covered by two thin horizontal bands or strips of non-conductive coating at 302A. These horizontal solder mask strips cover some of the via holes lined up underneath these strips, and effectively prevent degassing without impacting on the mechanical connection of the solder to the conductive landing pad. Similarly, FIGS. 3B and 3C show some other conductive landing pad geometries in which solder mask strips have been left on, at 302B and at 302C respectively, to cover via holes.

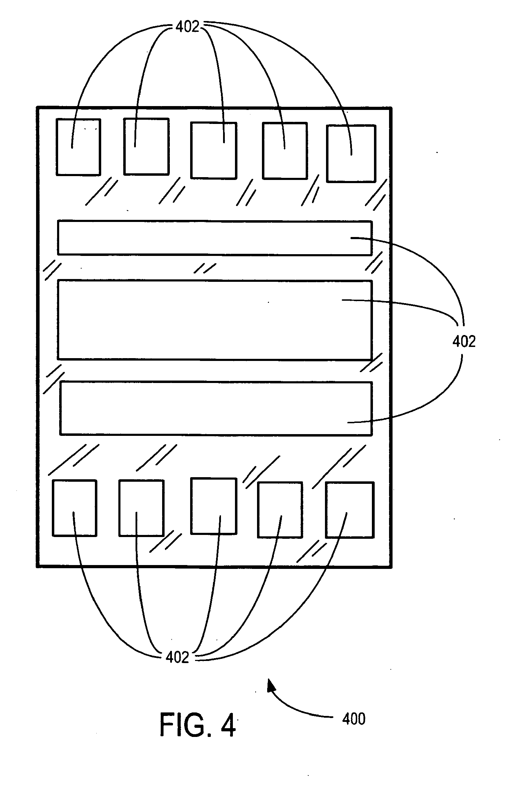

FIG. 4 shows an illustrative plan view of a screen or photo mask 400 having apertures 402 that may be used to leave uncovered areas of the solder mask to be exposed to a solder mask removal agent. This particular example of a screen or photo mask may be used to form the conductive landing pad geometry of FIG. 3A. In another embodiment, the solder mask removal agent may prepare exposed areas of the coating to be removed using a removal process such as chemical etching.

In another embodiment, rather than using a "negative" process, it will be appreciated that a positive process may be used instead to apply a coating over the via holes. Therefore, another screen may be used is a secondary coating application process which leaves at least some of the via holes exposed to the coating, after the conductive landing pad has been previously stripped to expose the conductive plate. However, it will be appreciated that this process would require an additional step in order to apply the coating.

While FIGS. 3A to 3C show the solder masks as being straight line strips, it will be appreciated that the screen or photo mask used to cover areas where the non-conductive coating is left on to cover via holes may be suitably cut to provide various alternative configurations, including solder mask strips that zigzag, or solder mask dots that cover the via holes individually.

While these non-conductive solder mask strips or dots may prevent an electrical connection between the solder and the covered conductive surface area, they do not prevent a mechanical connection, and there is a sufficiently large area provided at the conductive landing pad that remains exposed for an electrical connection. Rather, based on experimental results showing a significant reduction in the size of the voids, it is expected that there would be a net improvement in both the mechanical and electrical performance of the solder joint.

As an illustrative example of improvements seen in experimental results, shown below in Table A are voids measured as a percentage of the overall solder connection surface area (as defined by the outer boundary of the solder connection). As illustrated, over four samples, the overall size of voids averaged approximately 22% of the overall solder surface area, and went as high as 27% in one sample. As will be appreciated, such a large void area may significantly impair the mechanical properties of the solder connection, and also impact reliability of the solder connection over time.

**Table A - Single Pad Samples**

| | **Overall Void** | **Void 1** | **Void 2** | **Void 3** |
|---|---|---|---|---|
| **Sample 1** | 27.21% | 16.23% | 7.63% | 1.28% |
| **Sample 2** | 26.02% | 22.67% | 0.82% | 0.54% |
| **Sample 3** | 22.31% | 20.72% | 0.80% | 0.22% |
| **Sample 4** | 14.00% | 6.00% | 3.49% | 0.90% |
| **Average** | 22.38% | 16.40% | 3.18% | 0.73% |

In contrast, Table B below shows four samples with substantially similar conductive landing pad geometries as those used in Table A but having at least some of the via holes provided at their conductive landing pads left covered by a solder mask (e.g. as illustrated by example in FIGS. 3A to 3C above). All other variables were kept constant, including the oven reflow profile used to liquefy and then harden the solder. As shown, the overall average size of the voids was significantly reduced to approximately 6.7%.

**Table B - Split Pad Samples**

| | **Overall Void** | **Void 1** | **Void 2** | **Void 3** |
|---|---|---|---|---|
| **Sample 1** | 5.37% | 2.52% | 0.57% | 0.39% |
| **Sample 2** | 5.74% | 0.96% | 0.36% | 0.17% |
| **Sample 3** | 7.51% | 3.63% | 1.52% | 0.74% |
| **Sample 4** | 8.21% | 0.84% | 0.45% | 0.35% |
| **Average** | 6.71% | 1.99% | 0.72% | 0.41% |

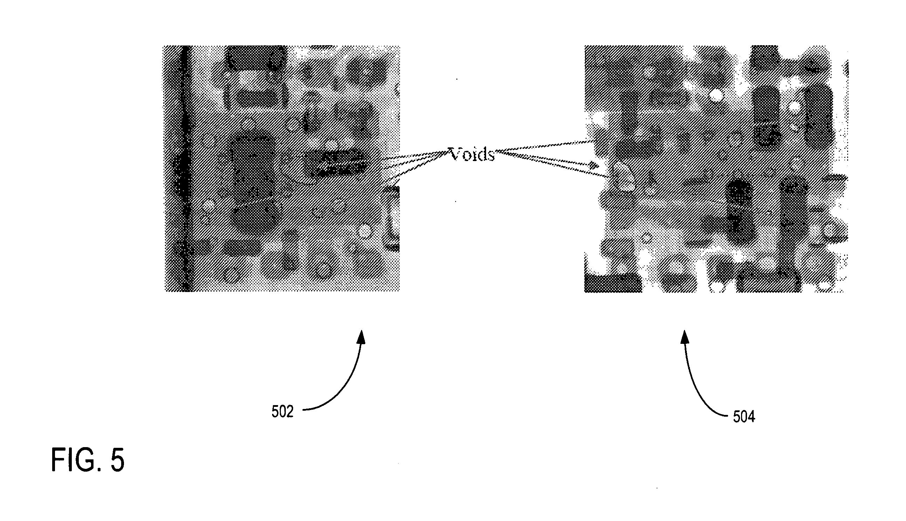

With all other variables kept constant, based on the above results, the inventor came to the conclusion that leaving the solder masks on over some of the via holes resulted in dramatically reduced voiding, thus significantly improving the solder connection. FIG. 5 shows a plan view of an X-ray image of some significantly improved results obtained from conductive landing pad geometries with solder masks.

Importantly, these significant results were obtained simply by modification of a step that was already being performed during the PCB manufacturing process, namely the application of a non-conductive coating onto the outer surface of the PCB, and the subsequent removal of areas of the non-conductive coating to expose underlying conductive landing pads. Therefore, there is no additional processing step required other than the redesign of the screen or photo mask to provide for leaving a solder mask on over some of the via holes located at a conductive landing pad. Therefore, this solution is very cost effective to implement.

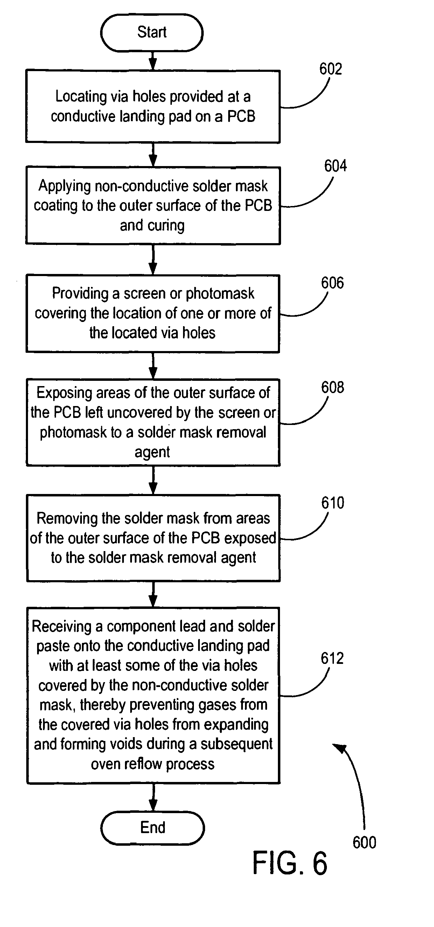

Now referring to FIG. 6, shown is a method in accordance with an embodiment corresponding to the above description. Method 600 begins, and at block 602 method 600 determines the location of via holes provided at a conductive landing pad on a PCB.

Method 600 then proceeds to block 604, where method 600 applies a non-conductive solder mask coating to the outer surface of the PCB, and dries the non-conductive solder mask coating.

Method 600 then proceeds to block 606, where method 600 provides a screen or photo mask covering the location of one or more of the located via holes.

Method 600 then proceeds to block 608, where method 600 exposes areas of the outer surface of the PCB left uncovered by the screen or photo mask to a solder mask removal agent.

Method 600 then proceeds to block 610, where method 600 removes the solder mask from areas of the outer surface of the PCB exposed to the solder mask removal agent.

Next, method 600 proceeds to block 612, where method 600 receives a component lead and solder paste onto the conductive landing pad with at least some of the via holes covered by the non-conductive solder mask, thereby preventing gases from the covered via holes from forming voids during the oven reflow process.

While illustrative embodiments have been described above, it will be appreciated that various changes and modifications may be made. More generally, the scope of the invention is defined by the following claims.

## Claims

1. A method of reducing solder voids in solder joints at conductive landing pads on a circuit board, comprising:
locating (202) formed cavities provided at the conductive landing pads, the cavities formed to a depth into laminate layers of the circuit board to connect only some of the laminate layers and trap air;
covering (204) at least some of the cavities at the conductive landing pads with a coating;
positioning (208) a screen over the circuit board, the screen covering the location of at least some of the cavities provided at the conductive landing pads;
exposing areas of the coating at the conductive landing pads left uncovered by the screen to a coating removal agent or a chemical etching agent; and
removing (210) the coating from areas of the conductive landing pads exposed to the coating removal agent or a chemical etching agent.

2. The method of claim 1, further comprising positioning the screen to cover the location of at least some of the cavities at the conductive landing pads covered in a pattern of strips, whereby more of the cavities may be left covered by the coating while reducing areas of the conductive landing pad covered by the coating after removal of the coating from areas of the conductive landing pad exposed to the coating removal agent or a chemical etching agent.

3. The method of claim 2, wherein locating the cavities provided at the conductive landing pads comprises locating the positions of the cavities using schematic x-y-coordinates relative to a reference point.

4. The method of claim 1, wherein the screen is a photo mask.

5. The method of claim 1, further comprising covering at least some of the cavities provided at a conductive landing pad at the same time that all other areas of the circuit board are covered.

6. The method of claim 5, further comprising removing the coating from desired areas of the conductive landing pad at the same time that the coating is removed from all other areas of the circuit board.

7. A system for reducing solder voids on a circuit board, the system comprising:
means to locate (202) cavities provided at the conductive landing pads, the cavities formed to a depth into laminate layers of the circuit board to connect only some of the laminate layers and trap air;
means to cover (204) at least some of the cavities at the conductive landing pads with a coating;
means to position (208) a screen over the circuit board, the screen covering the location of at least some of the cavities provided at the conductive landing pads;
means to expose areas of the coating at the conductive landing pad left uncovered by the screen to a coating removal agent or a chemical etching agent; and
means to remove (210) the coating from areas of the conductive landing pad exposed to the coating removal agent or a chemical etching agent.

## Patentansprüche

1. Ein Verfahren zum Reduzieren von Löthohlräumen in Lötstellen an leitenden Verbindungsstellen auf einer Leiterplatte, das aufweist:
Lokalisieren (202) von gebildeten Aussparungen, die an den leitenden Verbindungsstellen vorgesehen sind, wobei die Aussparungen mit einer Tiefe in laminierte Schichten der Leiterplatte ausgebildet sind, um nur einige der laminierten Schichten zu verbinden und Luft einzuschließen;
Abdecken (204) zumindest einiger der Aussparungen an den leitenden Verbindungsstellen mit einer Beschichtung;
Positionieren (208) eines Schirms über der Leiterplatte, wobei der Schirm die Stelle von zumindest einigen der Aussparungen abdeckt, die an den leitenden Verbindungsstellen vorgesehen sind;
Freilegen von Bereichen der Beschichtung an den leitenden Verbindungsstellen, die durch den Schirm unabgedeckt bleiben, für einen Beschichtungsentfernungsagent oder einen chemischen Ätzagent; und
Entfernen (210) der Beschichtung von Bereichen der leitenden Verbindungsstellen, die für den Beschichtungsentfernungsagent oder einen chemischen Ätzagent freiliegen.

2. Das Verfahren gemäß Anspruch 1, das weiter aufweist ein Positionieren des Schirms, um die Stelle von zumindest einigen der Aussparungen an den leitenden Verbindungsstellen abzudecken, die in einem Muster von Streifen abgedeckt sind, wodurch mehr der Aussparungen von der Beschichtung bedeckt bleiben können, während Bereiche der leitenden Verbindungsstelle, die von der Beschichtung abgedeckt sind, reduziert werden, nach einem Entfernen der Beschichtung von Bereichen der leitenden Verbindungsstelle, die für den Beschichtungsentfernungsagent oder einen chemischen Ätzagent freiliegen.

3. Das Verfahren gemäß Anspruch 2, wobei das Lokalisieren der Aussparungen, die an den leitenden Verbindungsstellen vorgesehen sind, aufweist ein Lokalisieren der Positionen der Aussparungen unter Verwendung von schematischen x-y-Koordinaten in Bezug auf einen Referenzpunkt.

4. Das Verfahren gemäß Anspruch 1, wobei der Schirm eine Fotomaske ist.

5. Das Verfahren gemäß Anspruch 1, das weiter aufweist ein Abdecken zumindest eines Teils der Aussparungen, die an einer leitenden Verbindungsstelle vorgesehen sind, zum gleichen Zeitpunkt, an dem alle anderen Bereiche der Leiterplatte abgedeckt werden.

6. Das Verfahren gemäß Anspruch 5, das weiter aufweist ein Entfernen der Beschichtung von gewünschten Bereichen der leitenden Verbindungsstelle zum gleichen Zeitpunkt, an dem die Beschichtung von allen anderen Bereichen der Leiterplatte entfernt wird.

7. Ein System zum Reduzieren von Löthohlräumen auf einer Leiterplatte, wobei das System aufweist:
Mittel zum Lokalisieren (202) von Aussparungen, die an den leitenden Verbindungsstellen vorgesehen sind, wobei die Aussparungen mit einer Tiefe in laminierte Schichten der Leiterplatte ausgebildet sind, um nur einige der laminierten Schichten zu verbinden und Luft einzuschließen;
Mittel zum Abdecken (204) zumindest einiger der Aussparungen an den leitenden Verbindungsstellen mit einer Beschichtung;
Mittel zum Positionieren (208) eines Schirms über der Leiterplatte, wobei der Schirm die Stelle von zumindest einigen der Aussparungen abdeckt, die an den leitenden Verbindungsstellen vorgesehen sind;
Mittel zum Freilegen von Bereichen der Beschichtung an der leitenden Verbindungsstelle, die durch den Schirm unabgedeckt bleiben, für einen Beschichtungsentfernungsagent oder einen chemischen Ätzagent; und
Mittel zum Entfernen (210) der Beschichtung von Bereichen der leitenden Verbindungsstelle, die für den Beschichtungsentfernungsagent oder einen chemischen Ätzagent freiliegen.

## Revendications

1. Procédé de réduction de vides de soudure dans des joints de soudure au niveau de zones de connexion conductrices sur une carte de circuits, comprenant :
la localisation (202) de cavités formées situées au niveau des zones de connexion conductrices, les cavités étant formées à une certaine profondeur dans des couches de stratification de la carte de circuits de façon à ne connecter que certaines des couches de stratification et à piéger de l'air ;
le recouvrement (204) d'au moins certaines des cavités au niveau des zones de connexion conductrices par un revêtement ;
le positionnement (208) d'un écran sur la carte de circuits, l'écran recouvrant l'emplacement d'au moins certaines des cavités situées au niveau des zones de connexion conductrices ;
l'exposition de zones du revêtement au niveau de la zone de connexion conductrice laissées non recouvertes par l'écran à un agent de retrait de revêtement ou à un agent de gravure chimique ; et
le retrait (210) du revêtement à partir de zones de la zone de connexion conductrice exposées à l'agent de retrait de revêtement ou à un agent de gravure chimique.

2. Procédé selon la revendication 1, comprenant de plus le positionnement de l'écran de façon à recouvrir l'emplacement d'au moins certaines des cavités au niveau des zones de connexion conductrices recouvertes en un motif de bandes, grâce à quoi davantage des cavités peuvent être laissées recouvertes par le revêtement tout en réduisant des surfaces de la zone de connexion conductrice recouvertes par le revêtement après le retrait du revêtement à partir de zones de la zone de connexion conductrice exposées à l'agent de retrait de revêtement ou à un agent de gravure chimique.

3. Procédé selon la revendication 2, dans lequel la localisation des cavités situées au niveau des zones de connexion conductrices comprend la localisation des positions des cavités à l'aide de coordonnées schématiques x-y par rapport à un point de référence.

4. Procédé selon la revendication 1, dans lequel l'écran est un photomasque.

5. Procédé selon la revendication 1, comprenant de plus le recouvrement d'au moins certaines des cavités situées au niveau d'une zone de connexion conductrice en même temps que toutes les autres zones de la carte de circuits sont recouvertes.

6. Procédé selon la revendication 5, comprenant de plus le retrait du revêtement à partir de zones désirées de la zone de connexion conductrice en même temps que le revêtement est retiré de toutes les autres zones de la carte de circuits.

7. Système pour réduire des vides de soudure sur une carte de circuits, le système comprenant :
des moyens pour localiser (202) des cavités situées au niveau des zones de connexion conductrices, les cavités étant formées à une certaine profondeur dans des couches de stratification de la carte de circuits de façon à ne connecter que certaines des couches de stratification et à piéger de l'air ;
des moyens pour recouvrir (204) au moins certaines des cavités au niveau des zones de connexion conductrices par un revêtement ;
des moyens pour positionner (208) un écran sur la carte de circuits, l'écran recouvrant l'emplacement d'au moins certaines des cavités situées au niveau des zones de connexion conductrices ;
des moyens pour exposer des zones du revêtement au niveau de la zone de connexion conductrice laissées non recouvertes par l'écran à un agent de retrait de revêtement ou à un agent de gravure chimique ; et
des moyens pour retirer (210) le revêtement à partir de zones de la zone de connexion conductrice exposées à l'agent de retrait de revêtement ou à un agent de gravure chimique.
